# DEMANDE DE BREVET EUROPEEN

(11) **EP 0 732 811 A1**
(43) Date de publication de la demande: **18.09.1996**
(21) Numéro de dépôt: 95810169.3
(22) Date de dépôt: 14.03.1995
(51) Int. Cl.: H03L 7/26

(54) **Etalon de fréquence atomique**

(71) Demandeur: OBSERVATOIRE CANTONAL DE NEUCHATEL, CH-2000 Neuchâtel (CH)
(72) Inventeur: Thomann, Pierre, CH-2052 Fontainemelon (CH); Jornod, Alain, CH-2013 Colombier (CH)
(74) Mandataire: BOVARD AG - Patentanwälte

(57) **Abrégé**

Etalon de fréquence atomique comprenant une cellule de résonance (41) placée dans un résonateur micro-ondes (53) entouré par un blindage électromagnétique (58). Un module laser (10) émet un faisceau lumineux qui atteint la cellule de résonance et est utilisé pour pomper optiquement le rubidium dans la cellule de résonance.

Le faisceau lumineux est conduit depuis le module laser jusqu'à la cellule de résonance par une fibre optique (14) traversant le blindage électromagnétique. Le chemin optique parcouru par le faisceau lumineux ne comporte pas d'élément de type séparateur de faisceau.

Des moyens d'asservissement utilisent le faisceau lumineux conduit par la fibre optique (14) pour contrôler le courant d'injection et/ou la température de la diode laser, de manière à stabiliser la fréquence d'émission lumineuse. La cellule de résonance (41) sert à la fois de cellule de résonance pour l'asservissement d'un oscillateur (54) générant via un multiplicateur de fréquence (55) le signal d'excitation du résonateur micro-ondes (53) et de cellule d'asservissement de la diode laser (11).

## Description

La présente invention concerne les étalons de fréquence atomique, et plus particulièrement les étalons de fréquence atomique utilisant une source de lumière, de préférence une diode laser, pour pomper optiquement une cellule de résonance placée dans un résonateur micro-ondes entouré d'un blindage électromagnétique.

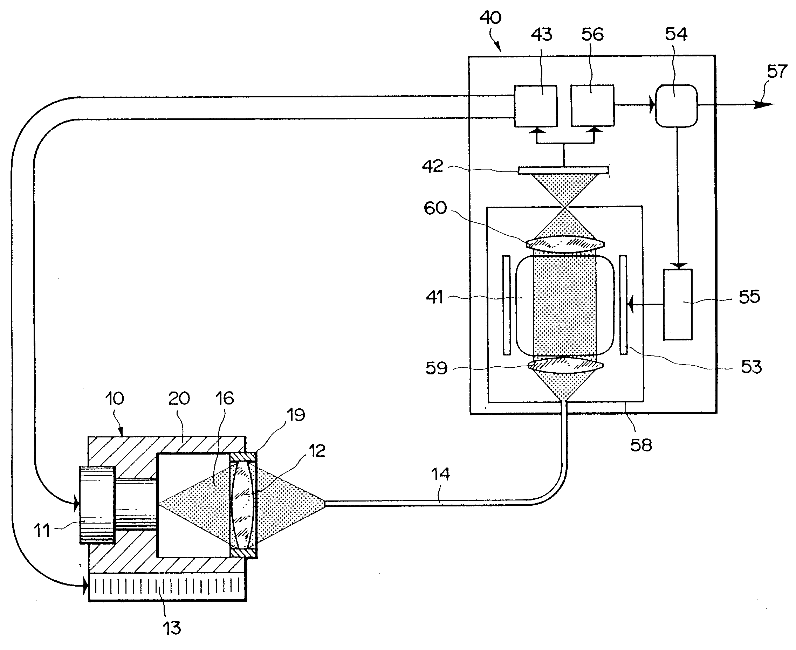

La demande de brevet française FR9203210, au nom de la demanderesse, décrit un étalon de fréquence atomique. On se référera utilement à ce document pour une étude détaillée du principe de fonctionnement de ces étalons, dont seules les caractéristiques nécessaires à la compréhension de l'invention seront reprises ici. La figure 1 de ce document illustre la construction d'un tel dispositif. Ils comprennent généralement une source de lumière 13, un résonateur micro-ondes 15, et des moyens de détection optiques 17. Un blindage électromagnétique 20b entoure la cavité du résonateur micro-ondes; il permet d'une part d'éviter que des champs magnétiques externes ne perturbent le résonateur, d'autre part d'éviter que le résonateur lui-même ne perturbe d'autres composants, tels que la source de lumière ou les moyens de détection optique. La cavité du résonateur micro-ondes renferme une cellule de résonance 16 contenant un gaz, par exemple une vapeur de rubidium ou de césium. Un oscillateur à quartz associé à un multiplicateur de fréquence 11 génère le signal d'excitation du résonateur micro-ondes.

La source de lumière génère un faisceau lumineux qui atteint la cellule de résonance et produit par pompage optique une inversion de la population entre les niveaux hypertins F=1 et F=2 de l'état fondamental des atomes de rubidium. La cellule de résonance devient pratiquement transparente lorsque tous les atomes ont atteint le niveau hyperfin supérieur F=2.

Il est également possible d'effectuer le pompage optique de manière à ce que l'inversion de population se fasse au bénéfice du niveau hyperfin inférieur F=1.

On applique alors, au moyen de l'oscillateur, une fréquence à la cavité du résonateur micro-ondes correspondant à l'énergie de transition entre les niveaux hyperfins, soit une fréquence voisine de 6835 MHz dans le cas du rubidium. Il en résulte une transition hyperfine, de sorte que l'inversion de population est détruite. La cellule redevient plus opaque. La quantité de lumière atteignant les moyens de détection optique est donc minimale lorsque la fréquence de l'oscillateur correspond, après multiplication, à la fréquence de transition. On asservit de cette manière l'oscillateur à la fréquence, très stable et très bien définie, correspondant à l'énergie de séparation des niveaux hyperfins.

Dans l'exemple de la demande susmentionnée, la source de lumière utilisée est une lampe, visible sur la figure 2, contenant un mélange de rubidium et d'argon, et est placée à l'intérieur d'une bobine d'excitation. Cet arrangement est complexe et coûteux. En outre, le volume occupé est important, et la lampe doit obligatoirement être placée à proximité de la cellule d'absorption. Ces deux éléments se perturbent donc mutuellement, et il est nécessaire de prévoir une grille 51 pour limiter ces perturbations. De surcroît, le rendement énergétique de ce dispositif est mauvais.

Cette réalisation ne convient donc que difficilement à des applications dans lesquelles le coût et le volume jouent un rôle important, et dans lesquelles la cellule doit être aussi efficacement que possible isolée des perturbations externes. On a donc déjà tenté dans l'art antérieur de remplacer la source lumineuse par une source qui ne présente pas ces inconvénients, par exemple par une diode laser.

Depuis quelques années, grâce par exemple à l'avènement des disques compacts et des imprimantes laser, les diodes laser sont produites en très grandes séries et sont donc devenues très économiques. Dans certains domaines d'applications, elles remplacent même de plus en plus les lasers traditionnels à gaz grâce à leurs avantages importants de miniaturisation, durée de vie, rendement et facilité de mise en oeuvre.

Il existe ainsi actuellement un grand nombre de types de diodes laser différents, par exemple les diodes à structure de double hétérojonction, les diodes de type DBR (Distributed Bragg Reflector), les diodes à cavité verticale, etc..., correspondant à un grand nombre de besoins différents.

Les diodes laser à structure à double hétérojonction de type AsGaAl par exemple ont trouvé une utilisation dans un grand nombre d'applications différentes. Elles émettent une lumière laser avec une longueur d'onde entre 750nm et 880 nm, proche du spectre visible et adaptée aux récepteurs photoélectriques à silicium habituels.

La fréquence lumineuse émise par ce type de diodes dépend de deux paramètres:
- le courant d'injection fait varier la fréquence de 3 GHz/mA, soit 0.006 nm/mA.
- la température fait varier la fréquence de 30GHz/°C, soit 0.06nm/°C.

Pour une application dans un étalon de fréquence atomique, il est nécessaire d'avoir une source laser émettant à une fréquence absolument stable. Il est donc nécessaire de stabiliser la fréquence d'émission en contrôlant le courant d'injection et/ou la température de la diode laser.

On sait réaliser des sources de courant constant produisant un courant de 150mA avec une précision de ± 5µA. Si on applique ce courant à une diode laser, l'imprécision de fréquence vaut donc df/f = 5·10⁻⁸ environ.

Sur une longue durée, il est difficile de garantir une précision de la température de la diode meilleure que ± 1mK. Cela correspond à une erreur df/f de 8·10⁻⁸.

Pour des étalons de fréquence atomique, la précision résultante par les moyens ci-dessus s'avère insuffisante. En outre, même si on parvenait à maintenir un courant et une température suffisamment constants, on ne pourrait pas avec cette méthode compenser les variations dues au vieillissement de la diode laser. Il est donc nécessaire de stabiliser la diode laser à l'aide d'un élément de référence externe.

La demande de brevet EP414194 (ANRITSU Corporation) décrit un autre étalon de fréquence atomique utilisant comme source lumineuse une diode laser dont la fréquence est stabilisée.

Sur la figure 1b en particulier, dans l'élément 24, on voit que le faisceau de la diode laser est partagé au moyen d'un cube séparateur de faisceau en un faisceau de mesure et un faisceau d'asservissement. Le faisceau d'asservissement atteint un résonateur optique 24d et un détecteur optique 24e fournit un signal utilisé par des moyens de contrôle 24f, 24g, 24h, 24i pour contrôler le courant d'injection de la diode laser, de manière à ce qu'elle émette précisément à la fréquence de résonance du résonateur optique 24e.

D'autres sytèmes de stabilisation de diodes laser existent dans lesquels la fréquence d'émission est asservie à la fréquence d'absorption d'une cellule contenant un gaz, par exemple une vapeur de rubidium, atténuant sélectivement certaines longueurs d'onde. On peut alors régler l'émission de la diode laser de manière à ce que l'intensité du faisceau traversant la cellule soit minimale, ce qui revient à caler la fréquence d'émission sur la fréquence du pic d'absorption de la cellule.

La demande susmentionnée EP414194 (Anritsu) présente toutefois également un certain nombre d'inconvénients rendant son utilisation problématique. Une partie du faisceau lumineux émis par la diode laser est réfléchie par la surface du cube séparateur et renvoyée vers la diode laser. Ce feed-back de lumière dans la diode laser modifie certaines caractéristiques d'émission, telles que la longueur d'onde ou le mode d'émission, et rend donc la stabilisation très difficile. Plusieurs solutions ont été proposées pour réduire, mais pas éliminer, le feed-back indésirable, en traitant les faces du cube séparateur avec des couches anti-réfléchissantes, en désalignant le cube par rapport à l'axe optique ou en utilisant un isolateur optique. Ces opérations permettent certes d'améliorer le dispositif, mais entraînent des complications et un surcoût.

De surcroît, lors de variations de température, la distance entre la diode laser et l'interface du cube séparateur se modifie en raison des dilatations. La phase et/ou l'amplitude de la lumière renvoyée dans la diode laser dépend donc de la température, rendant le comportement du dispositif difficilement prévisible.

En outre, le positionnement des divers composants est compliqué dans cette réalisation. La cellule d'absorption, dont le volume suivant le gaz choisi peut être assez important, doit être positionnée dans le chemin optique du faisceau lumineux, c'est-à-dire à proximité de la diode laser et du circuit de mesure. Si la diode laser est placée sur un circuit imprimé, il peut être difficile d'y fixer et d'ajuster correctement la cellule d'absorption.

En outre, dans cette réalisation, la diode laser, les composants de l'étalon atomique et le détecteur optique 24e sont insuffisamment protégés des perturbations électromagnétiques causées mutuellement et par l'extérieur. Le fonctionnement du dispositif s'en trouve donc perturbé. Même en plaçant un blindage électromagnétique autour du résonateur microondes, on ne résoudrait qu'imparfaitement le problème, puisque ce blindage devrait présenter des ouvertures de plusieurs millimètres de diamètre pour laisser entrer puis sortir le faisceau laser provenant de la diode laser. Le blindage ne pourrait donc remplir que très insuffisamment son rôle.

Un premier but de l'invention est donc de prévoir un étalon de fréquence atomique qui conserve les avantages de cette solution, tout en évitant les inconvénients mentionnés. En particulier, un des buts de l'invention est d'améliorer l'éfficacité du blindage autour du résonateur microondes.

Ce but est atteint dans l'invention par l'utilisation d'une fibre optique entre la source lumineuse, constituée par le module laser, et la cellule de résonance dans le résonateur. Cette fibre optique traverse le blindage autour du résonateur microondes. Il est ainsi possible de restreindre l'ouverture nécessaire pour l'introduction de la lumière dans le blindage au diamètre d'une fibre optique. En outre, cette fibre optique permet de placer très librement le module laser dans le dispositif, et donc d'optimiser le positionnement des divers éléments en fonction des contraintes de place, de construction ou de perturbations électromagnétiques ou thermiques par exemple.

Selon une autre caractéristique de l'invention, le module laser comporte une diode laser asservie grâce à des moyens d'asservissement utilisant un faisceau lumineux d'asservissement constitué par une partie au moins de la lumière émise par la face avant de la diode laser pour contrôler le courant d'injection et/ou la température de la diode laser, de manière à stabiliser la fréquence d'émission lumineuse. Avantageusement, l'invention a pour but un dispositif pouvant être réalisé avec des diodes laser ordinaires, couramment disponibles commercialement, de type DBR ou à cavité verticale (VCSEL), ou de préférence de type Fabry-Perot, ne nécessitant pas de précautions particulières lors de la fabrication ou du montage.

On connaît certes déjà des dispositifs, autres que des étalons de fréquence atomique, dans lesquels le faisceau lumineux d'asservissement nécessaire à l'asservissement d'une diode laser est prélevé au moyen d'une fibre optique placée directement devant la diode laser. Le brevet EP479118 (Dornier) décrit un tel dispositif.

Toutefois, ce dispositif utilise une fibre optique 8 de type monomode, difficile à mettre en oeuvre et nécessitant des précautions pour l'alignement avec la diode laser. En outre, une fibre monomode n'est pas apte à transporter un faisceau lumineux dans les conditions de stabilité requises. Il est en effet très difficile de maintenir des pertes de couplage stable avec une fibre monomode. Ce dispositif est donc seulement adapté à des dispositifs dans lesquels la stabilité exigée du faisceau lumineux de travail est peu critique, dans ce brevet pour des dispositifs du type décrit de capteurs à fibre optique. En aucun endroit, ce document ne suggère que le dispositif pourrait aussi être adapté à un étalon de fréquence atomique, ni comment il serait alors nécessaire de le modifier.

Le problème du feed-back n'est absolument pas résolu par le brevet EP479118 (Dornier). Cette solution ne peut donc pas être appliquée aisément à un étalon de fréquence atomique. En effet, pour effectuer la séparation entre le faisceau lumineux de travail et le faisceau lumineux d'asservissement, il est également nécessaire dans cette réalisation de prévoir un élément de type séparateur de faisceau, sous la forme ici d'un coupleur de fibres optiques 10. Ce type de coupleur est cependant au moins aussi difficile à produire qu'un cube séparateur de faisceau. La lumière pénétrant les coupleurs de type connus traverse une interface optique qui renvoie au travers de la fibre optique une partie de la lumière vers la diode laser 2.

En outre, le couplage d'une fibre monomode à une cavité de Fabry-Perot 12 tel qu'il est effectué génère un feed-back très important. Il n'est donc pas possible d'utiliser l'enseignement de ce brevet pour un étalon de fréquence atomique, dans lequel les sauts de mode d'émission de la diode laser sont absolument catastrophiques. L'homme du métier, souhaitant résoudre les problèmes de feed-back mentionnés en relation avec le document EP414194 (Anritsu), aurait donc plutôt été dissuadé par ce brevet EP479118 (Dornier) d'utiliser une fibre optique dans le cas d'un étalon de fréquence atomique, sans compter qu'il aurait alors fallu modifier profondément le dispositif décrit.

Un deuxième but de l'invention vise donc à résoudre le problème du feed-back de lumière dans la diode laser. De manière générale, l'invention a pour but un dispositif dans lequel toutes les sources de feed-back dans la diode laser sont réduites autant que possible.

Selon une autre caractéristique de l'invention, ce problème de feed-back est résolu en supprimant l'élément de type séparateur de faisceau sur le chemin optique parcouru par le faisceau lumineux entre la diode laser et la cellule de résonance.

Dans la réalisation du brevet EP414194 (Anritsu) susmentionné, le cube séparateur partage le faisceau lumineux émis par la diode laser en deux faisceaux, de mesure et d'asservissement, d'intensité sensiblement égale. Or les moyens d'asservissement peuvent généralement se contenter d'une petite fraction, typiquement de 2 ou 3 % environ, de l'intensité lumineuse nécessaire à l'étalon de fréquence atomique, alors que dans cette réalisation ils reçoivent la même intensité. La diode laser doit donc fonctionner à une puissance inutilement élevée, ce qui réduit sa longévité, accélère le vieillissement, produit un échauffement intempestif et gaspille de l'énergie.

On notera que le brevet EP479118 (Dornier) susmentionné ne résout pas davantage que la solution précédente le problème de la puissance à fournir à la diode laser. Les coupleurs de fibre optique courants partagent en effet le faisceau lumineux entrant en deux faisceaux d'intensité égale. Les moyens d'asservissement reçoivent par conséquent une intensité lumineuse égale au reste du dispositif, quand bien même ils pourraient dans beaucoup d'applications se contenter d'une fraction de cette intensité.

Un autre problème que l'invention se vise de résoudre concerne la limitation de la puissance qu'il est nécessaire de fournir à la diode laser.

Selon une autre caractéristique de l'invention, ce problème est résolu en utilisant comme faisceau lumineux pour l'asservissement le même faisceau que pour le pompage optique dans la cellule de résonance. On évite ainsi tous les problèmes liés au cube séparateur de faisceau, et la diode laser peut fonctionner au minimum de puissance nécessaire au pompage optique du gaz dans la cellule de résonance. Les problèmes de vieillissement et d'échauffement de la diode laser sont ainsi diminués et, en négligeant les pertes ou les éventuelles réductions volontaires de puissance au moyen d'un diaphragme, la totalité de l'énergie consommée par la diode est utilisée pour l'application de mesure ou de transmission. Grâce à cette caractéristique, il est possible limiter la puissance de fonctionnement de la diode laser.

Selon une autre caractéristique de l'invention, une seule cellule contenant un gaz, par exemple une vapeur de rubidium ou de césium, est utilisée à la fois comme cellule de résonance pour l'étalon de fréquence atomique et comme cellule d'absorption pour l'asservissement de la fréquence lumineuse émise par la diode laser. On réduit ainsi sensiblement le volume de l'ensemble du dispositif.

Un autre problème que l'invention se vise de résoudre concerne les variations de réflexions et de feed-back dues aux variations de température notamment dans le module laser.

Ce problème est résolu par l'invention grâce à des moyens de contrôle de température permettant de contrôler simultanément la température de la diode laser et de la lentille placée devant la diode laser.

L'invention a ainsi pour objet un étalon de fréquence atomique selon le brevet EP414194 (Anritsu), mais qui ne présente pas les inconvénients mentionnés. Un autre but de l'invention est de réaliser un étalon de fréquence atomique simple, peu onéreux et de volume réduit, tout en offrant une précision élevée.

D'autres avantages et caractéristiques de l'invention sont mentionnés dans les revendications annexées ainsi que dans la description et dans la figure unique montrant un exemple préférentiel de réalisation de l'invention.

L'étalon de fréquence atomique comprend un module laser 10 asservi en fréquence sur une cellule contenant une vapeur atomique ou moléculaire (par exemple du rubidium ou du césium). Le module laser 10 comprend une diode laser 11 qui émet un faisceau lumineux 16. En principe, on peut envisager d'utiliser divers types de diodes laser dans le module laser, par exemple des diodes laser à cavité de Fabry-Perot, à cavité verticale ou de type DBR. Dans les exemples de réalisation, la diode laser 11 utilisée est une diode laser à structure à double hétéro-jonction, de type AsGaAl. La diode laser est de préférence optimisée et encapsulée de manière à émettre de la lumière sur une seule face, désignée comme la face avant. Une lentille de focalisation 12, placée devant la diode laser, permet de récolter la lumière divergente émise par la diode laser et de la focaliser afin de coupler une fibre optique multimode 14 de manière à récolter la plus grande partie de l'intensité lumineuse émise. Cette lentille est fixée au boîtier 20 au moyen d'un support de lentille 19 réalisé en matériau synthétique ou de préférence en métal. La lentille elle-même peut être réalisée en matériau synthétique ou en verre, la forme de la lentille est seulement représentée schématiquement sur la figure. La lentille 12 peut éventuellement aussi être constituée par un groupe de lentilles. L'utilisation d'une fibre optique multimode 14 permet un alignement et un couplage à la diode laser moins critique vis-à-vis du feed-back que dans le cas d'une fibre monomode.

Le boîtier 20 du module laser est stabilisé en température grâce à des moyens de contrôle thermique 13. Ces moyens de contrôle thermique sont de préférence constitués par un élément Peltier. La diode laser 11, encapsulée de manière à émettre un faisceau de lumière 16 par la face avant, est fixée dans une ouverture du boîtier 20.

Les réflexions provoquées par la surface de la lentille de focalisation 12 et renvoyées vers la diode laser sont peu gênantes dans la mesure où la lentille est placée très près de la diode laser. Ce type de feed-back est moins critique pour la diode laser. Néanmoins, en vue de minimiser les réflexions, la lentille 12 peut être revêtue de couches anti-réflexions.

Selon une caractéristique de l'invention, les moyens de contrôle thermique 13 sont disposés de manière à contrôler simultanément la température de la diode laser 11 et celle de la lentille 12. Cette configuration permet de maintenir une température de la diode laser, de la lentille et de l'espace intermédiaire constante. Le feed-back optique dû à la lentille reste de cette manière absolument constant en phase et en amplitude, évitant ainsi des sauts de mode d'émission.

Alternativement, la fibre optique 14 peut être couplée directement à la diode laser, sans lentille intermédiaire.

Afin de limiter au maximum les transferts de chaleur, un vide d'air peut être crée dans la cavité entre la diode laser 11 et la lentille 12. Il est aussi possible de remplir cet espace avec un gaz tel que le xénon limitant les transferts de chaleur, comme cela est connu par exemple du brevet US5195102 (McLean et al.) ou de la demande de brevet susmentionnée FR9203210.

Le faisceau lumineux émis par la diode laser est transporté par la fibre optique multimode 14 jusqu'à l'étalon atomique de fréquence 40. La fibre optique traverse un blindage électromagnétique 58 qui enferme un résonateur microondes 53 et une cellule de résonance et d'absorption 41. L'ouverture dans le blindage 58 est minimale et a de préférence juste le diamètre nécessaire au passage de la fibre optique.

Une lentille 59 permet de collimater le faisceau à la sortie de la fibre optique, et de lui faire traverser la cellule de résonance et d'absorption 41. Une autre lentille 60, de l'autre côté de la cellule, concentre le faisceau, de manière à le faire passer par une deuxième ouverture de petit diamètre dans le blindage 58. La lumière traversant l'ouverture est mesurée par des moyens de détection optique 42 placés hors du blindage.

La cellule de résonance et d'absorption contient une vapeur atomique (rubidium ou césium par exemple) ou moléculaire. La lumière reçue par les moyens de détection optique 42 est minimale lorsque la fréquence lumineuse est égale à la fréquence du pic d'absorption du gaz de la cellule d'absorption, c'est-à-dire lorsque l'absorption est maximale. Les moyens de détection optique 42 fournissent un signal aux moyens d'asservissement 43 de la diode laser.

Ces moyens d'asservissement permettent de contrôler le courant d'injection de la diode laser 11 de manière à ce que le signal reçu par les moyens de détection optique 42 soit toujours minimal, c'est-à-dire de manière à ce que la fréquence lumineuse émise corresponde à la fréquence d'absorption du gaz dans la cellule d'absorption 41.

Dans une réalisation préférentielle, les moyens d'asservissement 43 agissent uniquement sur le courant d'injection appliqué à la diode laser 11, afin de varier la fréquence lumineuse émise. Il est cependant aussi tout à fait possible de stabiliser la fréquence lumineuse émise en agissant grâce aux moyens de contrôle thermique 13 sur la température de la diode laser, ou d'agir simultanément sur la température et sur le courant d'injection de la diode laser.

En agissant sur le courant d'injection de la diode laser, on modifie la fréquence d'émission de la diode laser, mais aussi l'intensité lumineuse émise. Si le pic d'absorption du gaz utilisé n'est pas très raide, les moyens de détection optique 42 risquent alors de détecter des variations davantage dues à la variation d'amplitude qu'à la variation de fréquence. Il peut alors être nécessaire d'effectuer une correction, par exemple en la prévoyant dans les moyens d'asservissement 43, ou en soustrayant le signal mesuré avant la cellule d'absorption du signal mesuré après.

Le même faisceau lumineux est également utilisé dans l'étalon de fréquence atomique 40 pour pomper optiquement les atomes dans la cellule de résonance et d'asservissement 41. Un seul faisceau lumineux sert donc simultanément de faisceau de travail et de faisceau d'asservissement.

La cellule 41 est placée dans un résonateur microondes 53 alimenté par un oscillateur à quartz 54 dont la fréquence est multipliée par un facteur prédéterminé adéquat, par exemple 1360, dans un multiplicateur de fréquence 55. Ce multiplicateur de fréquence remplit une double fonction de multiplicateur de fréquence et de synthétiseur. L'oscillateur fournit également le signal de sortie 57, caractérisé par une fréquence très stable et très bien définie.

Lorsque la fréquence de la lumière atteignant la cellule est voisine de la fréquence de résonance caractéristique de l'espèce atomique contenue dans la cellule, l'intensité lumineuse transmise et reçue par les moyens de détection optique 42 varie de manière résonante.

Le signal délivré par ces moyens de détection optique 42 est traité par un dispositif d'asservissement électronique 56 pour corriger la fréquence de l'oscillateur à quartz 54 et maintenir celle-ci dans le rapport prédéterminé avec la fréquence de résonance caractéristique de la vapeur atomique.

Dans cet exemple, un seul photodétecteur 42 est utilisé simultanément pour l'asservissement de la diode laser 11 à la fréquence d'absorption du gaz dans la cellule, et pour l'asservissement de l'oscillateur à quartz 54 à une fréquence liée par le facteur fixé dans le multiplicateur de fréquence 55 à la fréquence de résonance de ce gaz.

Pour l'exemple du rubidium, la fréquence optique d'absorption vaut 3,8 x 10¹² Hz, alors que la fréquence de résonance vaut 6,835 x 10⁹ Hz. La fréquence de l'oscillateur à quartz 54 vaut 5MHz et est augmentée par le multiplicateur de fréquence 55 à la fréquence de résonance.

Dans cet exemple, le résonateur microondes est un résonateur atomique à cellule de rubidium. L'invention s'applique cependant aussi à des résonateurs à cellule de césium ou de n'importe quel autre vapeur atomique ou moléculaire, ou de mélange de vapeurs. Ce pourrait aussi être un résonateur à jet atomique, par exemple à jet de rubidium ou de césium.

## Revendications

1. Etalon de fréquence atomique comprenant une cellule de résonance (41) placée dans un résonateur microondes (53) entouré par un blindage électromagnétique (58), un module laser (10) situé hors du blindage électromagnétique et émettant un faisceau lumineux qui atteint la cellule de résonance, ledit faisceau lumineux étant utilisé pour pomper optiquement un gaz dans la cellule de résonance, caractérisé en ce que ledit faisceau lumineux est conduit depuis le module laser jusqu'à la cellule de résonance par une fibre optique (14) traversant le blindage électromagnétique.

2. Etalon de fréquence atomique selon la revendication 1, caractérisé en ce que le module laser comporte une diode laser (11) asservie grâce à des moyens d'asservissement (43),
lesdits moyens d'asservissement utilisant une partie au moins du faisceaux lumineux émis par la face avant de la diode laser pour contrôler le courant d'injection et/ou la température de la diode laser, de manière à stabiliser la fréquence d'émission lumineuse.

3. Etalon de fréquence atomique selon l'une des revendications précédentes, caractérisé en ce que le chemin optique parcouru par le faisceau lumineux de travail ne comporte pas d'élément de type séparateur de faisceau.

4. Etalon de fréquence atomique selon la revendication 2 ou 3, caractérisé en ce que les moyens d'asservissement utilisent ledit faisceau lumineux conduit par la fibre optique (14) pour contrôler le courant d'injection et/ou la température de la diode laser, de manière à stabiliser la fréquence d'émission lumineuse.

5. Dispositif selon l'une des revendications 2 à 4, caractérisé en ce que ladite cellule de résonance (41) sert à la fois de cellule de résonance pour l'asservissement d'un oscillateur (54) générant via un multiplicateur de fréquence (55) le signal d'excitation du résonateur microondes (53) et de cellule d'asservissement de la diode laser (11).

6. Dispositif selon l'une des revendications 1 à 5, caractérisé en ce qu'il comporte en outre des moyens de détection optique (42) mesurant l'intensité du faisceau lumineux transmis par la cellule de résonance, et en ce que lesdits moyens de détection optique sont situés en dehors dudit blindage électromagnétique (58).

7. Dispositif selon l'une des revendications 2 à 6, caractérisé en ce que le module laser comporte en outre une lentille (12) permettant de couper ladite fibre optique à ladite diode laser, et des moyens de contrôle de température (13) permettant de contrôler simultanément la température de la diode laser (11) et de la lentille (12).

8. Dispositif selon l'une des revendications 2 à 6, caractérisé en ce que ladite fibre optique (14) est coupée directement à ladite diode laser.

9. Dispositif selon l'une des revendications 6 à 8, caractérisé en ce que lesdits moyens de détection optique consistent en un détecteur optique (42) mesurant l'intensité du faisceau lumineux transmis par la cellule de résonance et d'absorption et fournissant un signal utilisé par les moyens d'asservissement (43) pour régler le courant d'injection et/ou la température de la diode laser (11), de manière à stabiliser la fréquence de la lumière (16) émise par la diode laser, et par des moyens de correction (56) de la fréquence émise par l'oscillateur (54) générant va un multiplicateur de fréquence (55) le signal d'excitation du résonateur microondes (53).
